# FASCICULE DE BREVET EUROPEEN

(11) **EP 4 184 181 B1**
(45) Date de publication et mention de la délivrance du brevet: **16.07.2025**
(21) Numéro de dépôt: 22204365.5
(22) Date de dépôt: 28.10.2022
(51) Int. Cl.: G01R 19/155, G01R 19/25, G01R 25/00

(54) **SYSTÈME DE DÉTERMINATION DE PRÉSENCE DE TENSION POUR UN RÉSEAU ÉLECTRIQUE HAUTE TENSION**
SYSTEM ZUR BESTIMMUNG DER ANWESENHEIT VON SPANNUNG FÜR EIN HOCHSPANNUNGSNETZ
SYSTEM FOR DETERMINING THE VOLTAGE PRESENCE FOR A HIGH VOLTAGE ELECTRICAL NETWORK

(30) Priorité: 22.11.2021 FR 2112355
(43) Date de publication de la demande: 24.05.2023
(73) Titulaire: Schneider Electric Industries SAS, 92500 Rueil-Malmaison (FR)
(72) Inventeur: MOLLIER, Christophe, 38500 Coublevie (FR); GUILLAUD-ROLLIN, Etienne, 38130 Echirolles (FR)
(74) Mandataire: Schneider Electric

(56) Documents cités:
- EP-A1- 2 538 229
- EP-A1- 3 361 268
- FR-A1- 2 984 514
- FR-B1- 3 071 927
- US-A1- 2011 012 740

## Description

### Domaine technique

La présente divulgation concerne un système de détermination de présence de tension pour un réseau électrique haute tension, et une installation électrique associée.

### Technique antérieure

Classiquement, l'état de tension d'une installation électrique appartenant à un réseau électrique haute tension est déterminé à partir d'un système de détermination de présence de tension qui est installé sur une face avant de l'installation ou l'appareillage électrique. Le système de détermination de présence de tension indique, généralement visuellement, la présence de tension dans chaque phase de l'installation électrique, par exemple à partir de l'éclairage d'un voyant ou d'un écran à cristaux liquides (ACL ou LCD, de l'anglais « liquid cristal display ») associé à chacune desdites phases.

Le système de détermination de présence de tension peut être un système détecteur de tension, communément appelé VDS (de l'anglais « voltage detecting system ») et décrit par la norme CEI 61243-5, ou un système indicateur de présence de tension, communément appelé VPIS (de l'anglais « voltage presence indicating system ») et décrit par la norme CEI 62271-206, anciennement CEI 61958. Le système de détermination de présence de tension peut aussi être un système détecteur et indicateur de tension, ou VDIS (de l'anglais « voltage detecting and indicating system »), décrit par la norme CEI 62271-213, qui a remplacé et fusionné les normes CEI 61243-5 et CEI 62271-206.

Outre l'indication de présence de tension, les dispositifs VDS, VPIS et VDIS peuvent remplir, pour chaque phase de l'installation électrique, une fonction de mesure de la tension et une fonction de comparaison de phases. En particulier, un premier signal permettant d'estimer la tension sur chacune des phases est accessible depuis une borne de sortie du système de détermination de présence de tension, et un deuxième signal représentatif d'un angle de phase de la tension sur chaque phase est accessible depuis une autre borne de sortie du système de détermination de présence de tension. La fonction de comparaison de phases permet de coupler un comparateur de phases à deux dispositifs de signalisation d'installations électriques différentes pour vérifier la correspondance directe entre les phases des deux installations, afin d'éviter le croisement des phases, par exemple lors d'un raccordement de ces cellules durant une reconfiguration du réseau ou après toute intervention à la suite d'un incident.

Suivant les normes CEI 61243-5, CEI 62271-206 et CEI 62271-213, les fonctions d'indication de présence de tension, de mesure de la tension et de comparaison de phases du système de détermination de présence de tension sont câblées en parallèle. De ce fait, lorsque l'une de ces fonctions est déficiente, car par exemple en court-circuit, les autres fonctions seront aussi déficientes. Ceci entraine un risque majeur pour la sécurité d'un opérateur manipulant l'installation électrique car il ne sera pas alerté de la présence de tension dans celle-ci si, par exemple, un comparateur de phases défaillant est couplé à la borne de sortie respective du système de détermination de présence de tension.

FR 3 071 927 B1 divulgue l'emploi d'écrêteurs pour éviter ce problème dans une installation munie d'un dispositif VPIS. Les écrêteurs sont en particulier constitués de deux diodes Zener montées tête-bêche en série et qui sont disposées de sorte à éviter que le dysfonctionnement de l'une des fonctions du VPIS entraine le dysfonctionnement des autres fonctions.

Toutefois, la nouvelle norme CEI 62271-213 applicable aux dispositifs VDIS exige que les signaux de sortie soient en phase avec la tension du réseau, ce qui empêche l'utilisation de diodes Zener, actives ou passantes en fonctionnement nominal, qui amènent du déphasage au niveau des signaux de sortie. Il est donc nécessaire de trouver une solution qui garantisse que le dysfonctionnement de l'une des fonctions d'indication de présence de tension, de mesure de la tension ou de comparaison de phases dans un dispositif VDIS, n'entraine pas le dysfonctionnement des autres fonctions.

Au-delà de la nouvelle norme CEI 62271-213, il est généralement souhaité d'avoir aussi un signal de sortie représentatif en amplitude et en angle de la tension du réseau sur la borne de sortie associée à la fonction mesure de tension afin de pouvoir faire des mesures de puissance.

### Résumé

La présente divulgation vient améliorer la situation.

Il est proposé un système de détermination de présence de tension destiné à être raccordé à un capteur de mesure de tension pour au moins une phase d'un réseau électrique haute tension, le système comportant pour ladite au moins une phase :
- un indicateur visuel de présence d'une tension mesurée par le capteur de mesure de tension, dite tension de mesure,
- une première borne de sortie configurée pour recevoir un premier signal de sortie représentatif de la tension de mesure en amplitude et en angle de phase,
- une deuxième borne de sortie configurée pour recevoir un second signal de sortie représentatif de la tension de mesure en amplitude et en angle de phase, et
- une pluralité de composants linéaires,

les première et deuxième bornes de sortie étant reliées en aval de l'indicateur visuel,
le système étant configuré pour que les première et deuxième bornes de sortie soient isolées fonctionnellement l'une de l'autre et isolées fonctionnellement de l'indicateur visuel uniquement par la pluralité de composants linéaires.

L'indicateur visuel de présence, la première borne de sortie et la deuxième borne de sortie permettent au système de détermination de présence de tension d'assurer les fonctions d'indication de présence de tension, de mesure de la tension et de comparaison de phases du système de détermination de présence de tension.

Grâce à la pluralité de composants linéaires, les première et deuxième bornes de sortie sont isolées fonctionnellement l'une de l'autre, ce qui empêche qu'un disfonctionnement sur l'une des bornes de sortie ne provoque le dysfonctionnement de l'autre borne de sortie. De surcroit, la pluralité de composants linéaires assurant aussi que l'indicateur visuel de présence soit isolé fonctionnellement des première et deuxième bornes de sortie, on empêche également qu'un disfonctionnement sur l'une des bornes de sortie ne provoque le dysfonctionnement de l'indicateur visuel de présence, et vice versa.

Les trois fonctions du système de détermination de présence de tension sont ainsi isolées sans besoin d'employer des diodes Zener, mais uniquement à partir de la pluralité de composants linéaires.

Selon un autre aspect, la pluralité de composants linéaires comprend pour chaque phase un premier ensemble de composants linéaires relié à la première borne de sortie et un deuxième ensemble de composants linéaires relié à la deuxième borne de sortie.

Selon un autre aspect, le premier ensemble de composants linéaires et le deuxième ensemble de composants linéaires sont montés en parallèle l'un de l'autre.

Selon un autre aspect, chaque ensemble de composants linéaires présente une impédance comprenant une partie capacitive ou une partie résistive.

Selon un autre aspect, chaque ensemble de composants linéaires est une impédance de même type qu'une impédance du capteur de mesure de tension.

Selon un autre aspect, le système comprend pour chaque phase un module de protection électrique connecté entre un point d'entrée et la terre, le point d'entrée étant placé entre l'impédance du capteur de mesure de tension et l'indicateur visuel.

Selon un autre aspect, l'indicateur visuel comprend au moins une diode électroluminescente ou un écran à cristaux liquides, et est configuré pour s'activer quand un courant mesuré est au-dessus d'un premier seuil et pour s'éteindre quand le courant mesuré est en-dessous d'un deuxième seuil.

Selon un autre aspect, le premier seuil est égal à un courant associé à une tension égale à 45% d'une tension nominale phase-phase.

Selon un autre aspect, le deuxième seuil est égal à un courant associé à une tension égale à 10% de la tension nominale phase-phase.

L'invention a également pour objet une installation électrique comprenant au moins une cellule d'appareillage électrique et un système de détermination de présence de tension tel que décrit précédemment.

### Brève description des dessins

D'autres caractéristiques, détails et avantages apparaîtront à la lecture de la description détaillée ci-après, et à l'analyse des dessins annexés, sur lesquels :
Fig. 1

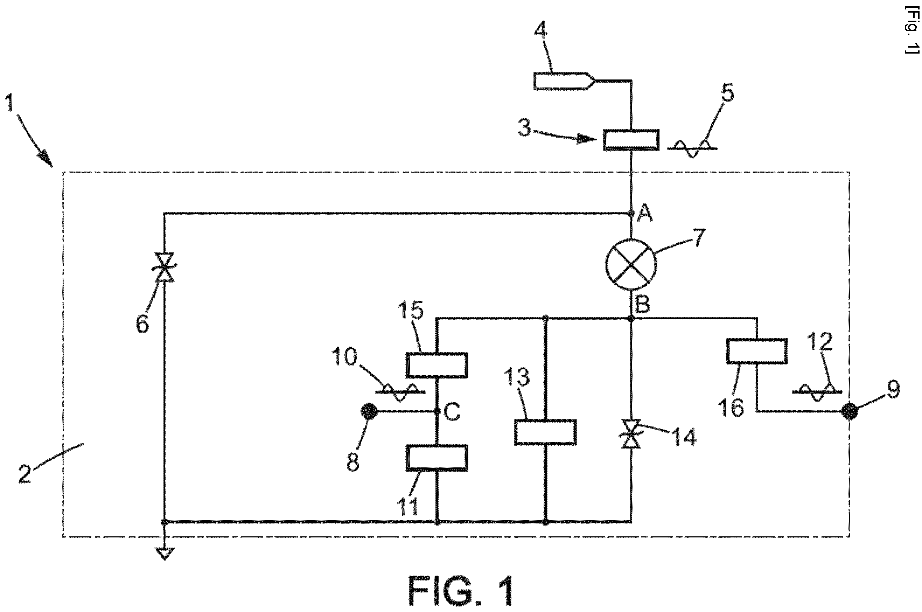

[Fig. 1] montre un schéma d'un circuit électrique comprenant un exemple de système de détermination de présence de tension selon l'invention.

### Description des modes de réalisation

Dans la description qui suit, par l'expression « haute tension » on entend toute tension supérieure à 1000 V.

La figure 1 montre un schéma d'un circuit électrique muni d'un système de détermination de présence de tension 1 pour une installation électrique appartenant à un réseau électrique haute tension. De préférence, l'installation électrique comprend également un dispositif multiphasé, telle une cellule d'appareillage électrique haute tension.

Dans ce qui suit, le système 1 est un dispositif VDIS conforme à la norme CEI 62271-213, mais il pourrait être aussi un dispositif VDS ou VPIS tels que présentés ci-avant.

Le système 1 comporte un circuit électronique 2 pour chaque phase de l'installation électrique. Chaque circuit électronique 2 peut comporter un ou plusieurs circuits imprimés.

Comme il ressort de la figure 1, le circuit électronique 2 est connecté à un capteur de mesure de tension 3. Le capteur 3 est reliée entre une phase 4 de l'installation électrique et un point d'entrée A du système 1. Le capteur 3 comprend de préférence une impédance de type capacitif, mais elle pourrait être aussi une impédance de type résistif. Le capteur 3 est par exemple de type capacité de traversée (également appelée capacité de « bushing »).

Le capteur 3 permet de mesurer une tension présente dans la phase 4 par rapport à la terre, qui sera aussi appelée « tension de mesure » dans ce qui suit. En particulier, le capteur 3 fournit un signal sinusoïdal 5 représentatif de la tension mesurée dans la phase 4 respective par rapport à la terre. Le signal 5 est reçu par le système 1 au niveau du point d'entrée A. Le système 1 est donc auto-alimenté par le capteur 3 à partir du signal sinusoïdal 5.

Maintenant seront décrits les différents composants que comprend le système 1 pour chaque phase de l'installation selon l'exemple non limitatif de la figure 1.

Le système 1 comprend un module de protection électrique 6 contre des surtensions transitoires. Le module de protection électrique 6 est connecté entre le point d'entrée A et la terre. Sur la figure 1, le module 6 comprend deux diodes Zener montées tête-bêche en série, mais il pourrait être aussi tout autre dispositif permettant de protéger contre les surtensions, tel un éclateur à gaz. En cas de surtension transitoire dans le système 1, par exemple due à une défaillance du capteur 3, le module 6 est configuré pour être traversé par la surtension, de sorte que celle-ci ne traverse pas le reste du système 1. La surtension transitoire est ainsi conduite vers la terre, ce qui limite le risque d'endommagement du système 1.

Le système 1 comporte en outre un indicateur visuel 7 de présence de tension. L'indicateur visuel 7 est situé entre le point d'entrée A et un nœud B du circuit 2. L'indicateur visuel 7 comprend de préférence au moins une diode électroluminescente (DEL) ou un écran à cristaux liquides (ou LCD pour ses sigles en anglais).

Avantageusement, l'indicateur visuel 7 fonctionne en ampèremètre. En particulier, l'indicateur 7 est configuré pour s'activer lorsqu'un courant mesuré en sortie du capteur 3 est au-dessus d'un premier seuil, dit seuil de présence de tension, et pour se désactiver lorsque le courant mesuré en sortie du capteur 3 est en-dessous d'un deuxième seuil, dit seuil d'absence de tension, inférieur au premier seuil. Entre le premier et le deuxième seuils, l'indicateur 7 est dans un état indéterminé, c'est-à-dire qu'il peut être soit activé soit désactivé.

Conformément à la norme CEI 62271-213, le premier seuil correspond au courant associé à une tension entre la phase et la terre égal à 45% d'une tension nominale phase-phase, tandis que le deuxième seuil correspond au courant associé à une tension entre la phase et la terre égal à 10% de la tension nominale phase-phase. Ces seuils peuvent bien entendu être réglés pour adapter le système 1 à d'autres normes.

L'indicateur visuel 7 participe donc à la fonction du système 1 d'indication de présence de tension, notamment de présence de la tension de mesure.

Le système 1 comprend en outre une première borne de sortie 8 et une deuxième borne de sortie 9. Les bornes de sortie 8, 9 sont reliées en aval de l'indicateur visuel 7 vis-à-vis d'un courant circulant dans le circuit 2.

Le système 1 comprend aussi une impédance 11 située entre un nœud C auquel est relié la borne 8, et la terre. L'impédance 11 peut être une capacité ou une résistance selon que le capteur 3 est capacitif ou résistif.

La borne de sortie 8 reçoit un premier signal de sortie 10 mesuré entre le nœud C et la terre, de préférence sinusoïdal.

Le signal 10 est représentatif de la tension de mesure en amplitude et en angle de phase. Plus précisément, le signal 10 représente une image de tension proportionnelle et en phase à la tension mesurée dans la phase 4 par rapport à la terre.

A partir du signal 10, il est possible de déterminer les différents paramètres de la tension de mesure. Un appareil externe, tel un relais de contrôle de tension, peut être connecté à la borne de sortie 8 afin d'exploiter le signal 10.

Le système 1 peut donc assurer sa fonction de mesure de la tension à partir de la borne de sortie 8.

La borne de sortie 9 reçoit un deuxième signal de sortie 12, sinusoïdal. Le signal 12 est représentatif de la tension de mesure en amplitude et en angle de phase et peut être exploité par un appareil externe, tel un comparateur de phases, connecté à la borne de sortie 9. Le signal 12 permet de vérifier la concordance des phases entre les deux extrémités d'une boucle de distribution électrique afin d'éviter le croisement des phases qui amènerait un court-circuit. Pour cela, le comparateur de phases est connecté aux bornes de sortie 9 des systèmes de détermination de présence de tension 1 des deux appareillages concernés.

Le système 1 peut donc assurer sa fonction de comparaison de phases à partir de la borne de sortie 9.

Comme clairement montré sur la figure 1, et suivant les normes relatives aux dispositifs VDIS, VPIS et VDS, les fonctions d'indication de présence de tension, de mesure de tension et de comparaison de phases dans le système 1 sont câblées en parallèle.

Le système 1 peut comprendre aussi une impédance 13, dite impédance de pied, et un limiteur de tension 14.

L'impédance de pied 13 est branchée entre la terre et le nœud B. L'impédance 13 peut être une capacité ou une résistance. L'impédance 13 permet de déterminer la valeur de tension nominale phase-phase nécessaire pour que les fonctions d'indication de présence de tension, de mesure de la tension et de comparaison de phases du système 1 soient fonctionnelles.

Le limiteur de tension 14 est branché en parallèle de l'impédance 13. En particulier, le limiteur de tension 14 est connecté entre le nœud B et la terre. Sur l'exemple de la figure 1, le limiteur de tension 14 est formé par deux diodes Zener montées tête-bêche en série. Avantageusement, le limiteur de tension 14 est configuré pour s'activer uniquement lorsque la tension entre la phase et la terre est égale ou supérieure à 120% de la tension nominale phase-phase, ce qui permet que l'indicateur visuel 7 reste fonctionnel même lorsque la tension de mesure est élevée.

Le système 1 comprend en outre une pluralité de composant linéaires. Avantageusement, au moins un composant linéaire est disposé entre le nœud B et la borne de sortie 8 et au moins un composant linéaire est disposé entre le nœud B et la borne de sortie 9.

Sur la figure 1, le système 1 comprend en particulier un premier ensemble de composants linéaires 15 et un deuxième ensemble de composants linéaires 16, mais ceci n'est pas limitatif. Chaque ensemble de composants linéaires 15, 16 comprend au moins un composant linéaire.

Le premier ensemble de composants linéaires 15 est relié à la borne de sortie 8. Plus précisément, le premier ensemble de composants linéaires 15 est branché entre les nœuds B et C, en série avec l'impédance 11. Le deuxième ensemble de composants linéaires 16 est relié à la borne de sortie 9. Plus précisément, le deuxième ensemble de composants linéaires 16 est branché entre le nœud B et la borne 9.

Les ensembles de composants linéaires 15 et 16 sont donc montés en parallèle l'un de l'autre. Les ensembles de composants linéaires 15 et 16 sont en outre reliés en série avec les appareils externes éventuellement connectés aux bornes de sortie 8 et 9 respectivement. Par ailleurs, les ensembles de composants linéaires 15 et 16 sont montés en aval de l'indicateur visuel 7 vis-à-vis du courant circulant dans le circuit 2.

De préférence, les ensembles de composants linéaires 15, 16 sont des impédances pouvant comporter une partie capacitive ou une partie résistive. Avantageusement, chaque ensemble de composants linéaires 15, 16 est une impédance de même type que le capteur 3. Ainsi, si le capteur 3 est un capteur de tension capacitif, les ensembles de composants linéaires 15, 16 seront des impédances capacitives, tandis que si le capteur 3 est un capteur de tension résistif, les ensembles de composants linéaires 15, 16 seront des impédances résistives. Les valeurs des ensembles de composants linéaires 15, 16 sont dépendantes de la tension dans l'installation électrique et de la valeur du capteur 3.

Les fonctions de mesure de tension et de comparaison de phases dans le système 1 étant câblées en parallèle, elles utilisent la même tension primaire. Ceci impliquerait qu'une défaillance ou un court-circuit de l'une des bornes 8, 9 provoquerait un court-circuit sur les fonctions de mesure de tension et de comparaison de phases. Cependant, l'arrangement des ensembles de composants linéaires 15, 16 dans le système 1 permet d'isoler fonctionnellement les bornes de sortie 8, 9 entre elles. En particulier, lorsqu'un court-circuit se produit sur l'une des bornes de sortie 8, 9, le deuxième ensemble de composants linéaires 16 et le premier ensemble de composants linéaires 15 respectivement assurent que la tension et le courant disponibles sur la borne de sortie contraire 9, 8 soient supérieurs à la tension et au courant associés au deuxième seuil (seuil d'absence de tension) si la tension et le courant dans le système 1 sont supérieurs au premier seuil (seuil de présence tension).

Par ailleurs, l'arrangement des bornes de sortie 8, 9 et des ensembles de composants linéaires 15, 16 en aval de l'indicateur 7 dans le système 1 permet d'isoler fonctionnellement les bornes de sortie 8, 9 de l'indicateur visuel 7. Ceci permet, en cas de défaillance ou court-circuit de l'une des bornes 8, 9, que le courant qui parcourt l'indicateur visuel 7 reste du même ordre de grandeur que le courant à la sortie du capteur 3. L'élément visuel 7 reste donc activé lorsque la tension et le courant dans le système 1 sont supérieurs à la tension et au courant associés au premier seuil. Ainsi, on limite les risques pour la sécurité de l'opérateur manipulant l'installation électrique.

## Revendications

1. Système de détermination de présence de tension (1) destiné à être raccordé à un capteur de mesure de tension (3) pour au moins une phase (4) d'un réseau électrique haute tension, le système (1) comportant pour ladite au moins une phase (4) :
- un indicateur visuel (7) de présence d'une tension mesurée par le capteur de mesure de tension (3), dite tension de mesure,
- une première borne de sortie (8) configurée pour recevoir un premier signal de sortie (10) représentatif de la tension de mesure en amplitude et en angle de phase,
- une deuxième borne de sortie (9) configurée pour recevoir un second signal de sortie (12) représentatif de la tension de mesure en amplitude et en angle de phase, et
- une pluralité de composants linéaires (15, 16),
les première et deuxième bornes de sortie (8, 9) étant reliées en aval de l'indicateur visuel (7),
le système (1) étant configuré pour que les première et deuxième bornes de sortie (8, 9) soient isolées fonctionnellement l'une de l'autre et isolées fonctionnellement de l'indicateur visuel (7) uniquement par la pluralité de composants linéaires.

2. Système (1) selon la revendication 1, dans lequel la pluralité de composants linéaires comprend pour chaque phase (4) un premier ensemble de composants linéaires (15) relié à la première borne de sortie (8) et un deuxième ensemble de composants linéaires (16) relié à la deuxième borne de sortie (9).

3. Système (1) selon la revendication précédente, dans lequel le premier ensemble de composants linéaires (15) et le deuxième ensemble de composants linéaires (16) sont montés en parallèle l'un de l'autre.

4. Système (1) selon l'une des revendications précédentes, dans lequel chaque ensemble de composants linéaires (15, 16) présente une impédance comprenant une partie capacitive ou une partie résistive.

5. Système (1) selon l'une des revendications précédentes, dans lequel chaque ensemble de composants linéaires (15, 16) est une impédance de même type qu'une impédance du capteur (3) de mesure de tension.

6. Système (1) selon l'une des revendications précédentes, comprenant pour chaque phase (4) un module de protection électrique (6) connecté entre un point d'entrée (A) et la terre, le point d'entrée (A) étant placé entre l'impédance du capteur (3) de mesure de tension et l'indicateur visuel (7).

7. Système (1) selon l'une des revendications précédentes, dans lequel l'indicateur visuel (7) comprend au moins une diode électroluminescente ou un écran à cristaux liquides, et est configuré pour s'activer quand un courant mesuré est au-dessus d'un premier seuil et pour s'éteindre quand le courant mesuré est en-dessous d'un deuxième seuil.

8. Système (1) selon la revendication précédente, dans lequel le premier seuil est égal à un courant associé à une tension égale à 45% d'une tension nominale phase-phase.

9. Système (1) selon la revendication 7 ou la revendication 8, dans lequel le deuxième seuil est égal à un courant associé à une tension égale à 10% de la tension nominale phase-phase.

10. Installation électrique comprenant au moins une cellule d'appareillage électrique et un système de détermination de présence de tension (1) selon l'une des revendications précédentes.

## Patentansprüche

1. System zur Bestimmung des Vorliegens von Spannung (1), das dazu bestimmt ist, an einen Spannungsmesssensor (3) für mindestens eine Phase (4) eines elektrischen Hochspannungsnetzes angeschlossen zu werden, wobei das System (1) für die mindestens eine Phase (4) umfasst:
- einen optischen Anzeiger (7) für das Vorliegen einer von dem Spannungsmesssensor (3) gemessenen Spannung, Messspannung genannt,
- eine erste Ausgangsklemme (8), die dazu ausgestaltet ist, ein erstes Ausgangssignal (10) zu empfangen, das hinsichtlich Amplitude und Phasenwinkel für die Messspannung repräsentativ ist,
- eine zweite Ausgangsklemme (9), die dazu ausgestaltet ist, ein zweites Ausgangssignal (12) zu empfangen, das hinsichtlich Amplitude und Phasenwinkel für die Messspannung repräsentativ ist, und
- eine Mehrzahl von linearen Komponenten (15, 16),
wobei die erste und die zweite Ausgangsklemme (8, 9) hinter dem optischen Anzeiger (7) verbunden sind,
wobei das System (1) dazu ausgestaltet ist, dass die erste und die zweite Ausgangsklemme (8, 9) nur durch die Mehrzahl von linearen Komponenten voneinander funktionell isoliert und von dem optischen Anzeiger (7) funktionell isoliert sind.

2. System (1) nach Anspruch 1, wobei die Mehrzahl von linearen Komponenten für jede Phase (4) eine erste Anordnung von linearen Komponenten (15), die mit der ersten Ausgangsklemme (8) verbunden ist, und eine zweite Anordnung von linearen Komponenten (16), die mit der zweiten Ausgangsklemme (9) verbunden ist, umfasst.

3. System (1) nach dem vorhergehenden Anspruch, wobei die erste Anordnung von linearen Komponenten (15) und die zweite Anordnung von linearen Komponenten (16) parallel zueinander geschaltet sind.

4. System (1) nach einem der vorhergehenden Ansprüche, wobei jede Anordnung von linearen Komponenten (15, 16) eine Impedanz aufweist, die einen kapazitiven Teil oder einen resistiven Teil umfasst.

5. System (1) nach einem der vorhergehenden Ansprüche, wobei jede Anordnung von linearen Komponenten (15, 16) eine Impedanz desselben Typs wie eine Impedanz des Spannungsmesssensors (3) ist.

6. System (1) nach einem der vorhergehenden Ansprüche, das für jede Phase (4) ein elektrisches Schutzmodul (6) umfasst, das zwischen einem Eingangspunkt (A) und der Erde angeschaltet ist, wobei der Eingangspunkt (A) zwischen der Impedanz des Spannungsmesssensors (3) und dem optischen Anzeiger (7) angeordnet ist.

7. System (1) nach einem der vorhergehenden Ansprüche, wobei der optische Anzeiger (7) mindestens eine Leuchtdiode oder ein Flüssigkristalldisplay umfasst und dazu ausgestaltet ist, sich einzuschalten, wenn ein gemessener Strom über einem ersten Schwellwert liegt, und sich auszuschalten, wenn der gemessene Strom unter einem zweiten Schwellenwert liegt.

8. System (1) nach dem vorhergehenden Anspruch, wobei der erste Schwellenwert gleich einem Strom ist, der einer Spannung zugeordnet ist, die 45 % einer Phase-Phase-Nennspannung beträgt.

9. System (1) nach Anspruch 7 oder Anspruch 8, wobei der zweite Schwellenwert gleich einem Strom ist, der einer Spannung zugeordnet ist, die 10 % der Phase-Phase-Nennspannung beträgt.

10. Elektrische Anlage, umfassend mindestens eine Zelle mit elektrischen Betriebsmitteln und ein System zur Bestimmung des Vorliegens von Spannung (1) nach einem der vorhergehenden Ansprüche.

## Claims

1. Voltage presence determination system (1) intended to be connected to a voltage measurement sensor (3) for at least one phase (4) of a high-voltage electrical network, the system (1) comprising, for said at least one phase (4):
- a visual indicator (7) of the presence of a voltage measured by the voltage measurement sensor (3), referred to as the measured voltage,
- a first output terminal (8) configured to receive a first output signal (10) which is representative of the measured voltage in terms of phase angle and amplitude,
- a second output terminal (9) configured to receive a second output signal (12) which is representative of the measured voltage in terms of phase angle and amplitude, and
- a plurality of linear components (15, 16),
the first and second output terminals (8, 9) being connected downstream of the visual indicator (7),
the system (1) being configured so that the first and second output terminals (8, 9) are functionally isolated from one another and functionally isolated from the visual indicator (7) only by the plurality of linear components.

2. System (1) according to Claim 1, wherein the plurality of linear components comprises, for each phase (4), a first set of linear components (15) which is connected to the first output terminal (8) and a second set of linear components (16) which is connected to the second output terminal (9).

3. System (1) according to the preceding claim, wherein the first set of linear components (15) and the second set of linear components (16) are connected in parallel with one another.

4. System (1) according to one of the preceding claims, wherein each set of linear components (15, 16) has an impedance comprising a capacitive portion or a resistive portion.

5. System (1) according to one of the preceding claims, wherein each set of linear components (15, 16) is an impedance of the same type as an impedance of the voltage measurement sensor (3).

6. System (1) according to one of the preceding claims, comprising, for each phase (4), an electrical protection module (6) connected between an entry point (A) and earth, the entry point (A) being placed between the impedance of the voltage measurement sensor (3) and the visual indicator (7).

7. System (1) according to one of the preceding claims, wherein the visual indicator (7) comprises at least one light-emitting diode or a liquid-crystal display, and is configured to be activated when a measured current is above a first threshold and to be switched off when the measured current is below a second threshold.

8. System (1) according to the preceding claim, wherein the first threshold is equal to a current associated with a voltage which is equal to 45% of a phase-to-phase nominal voltage.

9. System (1) according to Claim 7 or Claim 8, wherein the second threshold is equal to a current associated with a voltage which is equal to 10% of the phase-to-phase nominal voltage.

10. Electrical apparatus comprising at least one unit of electrical switchgear and a voltage presence determination system (1) according to one of the preceding claims.
